# FASCICULE DE BREVET EUROPEEN

(11) **EP 3 782 006 B1**
(45) Date de publication et mention de la délivrance du brevet: **22.06.2022**
(21) Numéro de dépôt: 19718187.8
(22) Date de dépôt: 19.04.2019
(51) Int. Cl.: G06F 1/16, H05K 1/14

(54) **DISPOSITIF D'ACQUISITION DE DONNÉES POUR L'INSTRUMENTATION D'UNE STRUCTURE**
DATENERFASSUNGSSYSTEM UM EINE STRUKTUR ZU INSTRUMENTIEREN.
DATA CAPTURE SYSTEM FOR INSTRUMENTING A STRUCTURE

(30) Priorité: 19.04.2018 FR 1853458
(43) Date de publication de la demande: 24.02.2021
(73) Titulaire: Safran Data Systems, 91978 Courtaboeuf Cedex (FR)
(72) Inventeur: GUERRERO, Ghislain, 78210 SAINT CYR L'ECOLE (FR); PINTO, Olivier, 91300 MASSY (FR)
(74) Mandataire: Regimbeau
(86) Numéro de dépôt international: PCT/EP2019/060247
(87) Numéro de publication internationale: WO 2019/202155

(56) Documents cités:
- US-A1- 2004 160 742
- US-A1- 2016 259 376
- US-B1- 6 402 031

## Description

### DOMAINE DE L'INVENTION

L'invention concerne un dispositif d'acquisition de données, destiné à l'instrumentation de véhicules (véhicule terrestre, aéronef, véhicule ferroviaire) ou d'équipements industriels (équipement de production d'énergie électrique).

### ETAT DE LA TECHNIQUE

L'instrumentation consiste à installer des capteurs et des dispositifs d'acquisition embarqués sur des véhicules ou des équipements industriels à tester, afin de réaliser des mesures pendant des procédures de tests ou des contrôles qualité. Les données peuvent par exemple être des données physiques (chocs, vibrations) ou environnementales (température, humidité, pression). Les dispositifs d'acquisition de données collectent et mettent en forme les données issues des différents capteurs.

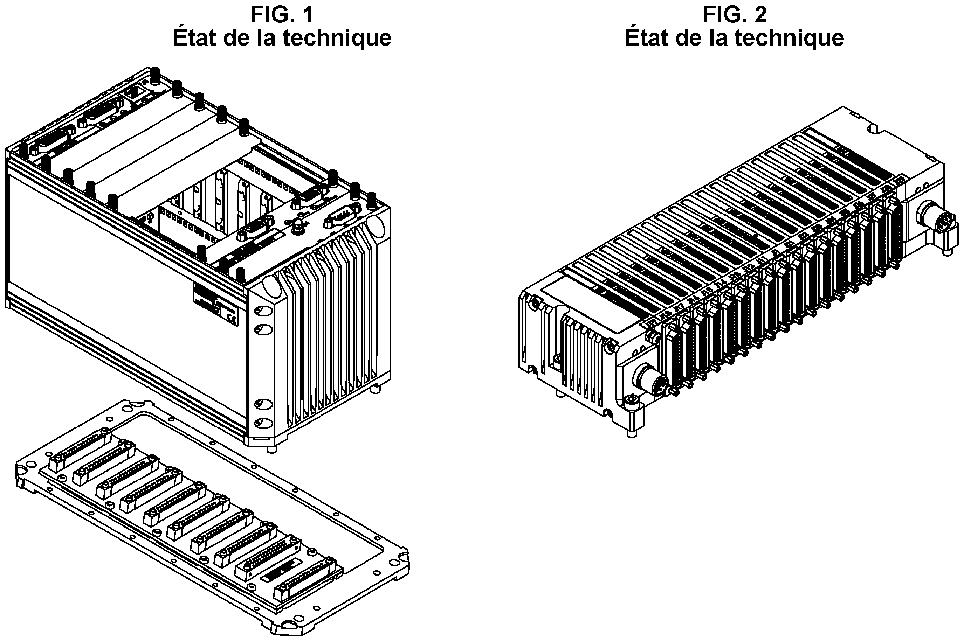

La figure 1 représente de manière schématique un premier exemple d'un dispositif d'acquisition connu. Le dispositif d'acquisition comprend un châssis et une série de modules électroniques propres à être insérés dans le châssis à la manière de tiroirs. Le châssis comprend des parois latérales délimitant une ouverture d'insertion et une paroi de fond. Les parois latérales sont munies de glissières dans lesquelles les modules électroniques peuvent être insérés. Le dispositif comprend en outre une carte électronique de raccordement fixée sur la paroi de fond à l'intérieur du châssis. La carte électronique comprend une série de connecteurs. Chaque module électronique est inséré dans l'une des glissières et est raccordé électriquement à la carte électronique via l'un des connecteurs. Ce dispositif permet l'assemblage de différents modules électroniques propres à acquérir et traiter des signaux en provenance de différents capteurs en fonction des besoins.

Un inconvénient de ce dispositif est qu'il est encombrant, de sorte qu'il ne peut généralement pas être installé à proximité des capteurs. Ainsi, des câbles doivent être installés pour relier les différents capteurs au dispositif d'acquisition. De plus, le châssis doit être fixé sur la structure à instrumenter par l'intermédiaire d'une platine d'adaptation et de vis de fixation. De ce fait, le dispositif est encombrant et son installation nécessite de prévoir des passages de câbles et de percer des trous dans la structure à instrumenter pour l'insertion des vis de fixation. Ainsi, l'instrumentation du véhicule ou de l'équipement à tester peut modifier sensiblement les performances du véhicule ou de l'équipement. Cet impact de l'instrumentation sur les performances du véhicule ou de l'équipement à tester doit généralement être évalué, préalablement aux essais, afin de corriger les mesures obtenues lorsque cela est possible. Par ailleurs, une fois que le véhicule ou l'équipement à tester a été instrumenté, il n'est généralement pas possible de modifier facilement la configuration des capteurs, du dispositif d'acquisition et du câblage, par exemple lorsque l'on souhaite ajouter un capteur.

La figure 2 représente de manière schématique un deuxième exemple de dispositif d'acquisition. Le dispositif d'acquisition comprend une série de modules électroniques. Chaque module comprend un boîtier individuel. Les boîtiers des modules électroniques sont assemblés entre eux pour former un empilement, et les modules électroniques sont raccordés entre eux par le biais de connecteurs.

Un tel dispositif est généralement moins encombrant que le dispositif représenté sur la figure 1. Toutefois, ce dispositif présente également l'inconvénient qu'il doit être fixé sur la structure à instrumenter par l'intermédiaire d'une platine d'adaptation et de vis de fixation. De plus, des câbles doivent également être installés pour relier les différents capteurs au dispositif d'acquisition. Ainsi, comme avec le dispositif de la figure 1, le dispositif représenté sur la figure 2 ne permet pas de modifier facilement la configuration des capteurs, du dispositif d'acquisition et du câblage une fois que le véhicule ou l'équipement à tester a été instrumenté.

Le document US 2004/160742 décrit un montage comprenant un empilement de dispositifs électroniques entre lesquels sont interposés des couches en élastomère conducteur anisotropique. L'empilement est pressé de manière à interconnecter les dispositifs électroniques entre eux à travers l'empilement.

Le document US 6 402 031 décrit une plateforme modulaire obtenue par l'empilement d'une pluralité de modules électroniques cylindriques. Les modules électroniques sont raccordés entre eux par des contacts disposés en périphérie des modules électroniques.

### RESUME DE L'INVENTION

Un but de l'invention est de proposer un dispositif d'acquisition de données qui présente un encombrement et un impact réduits sur la structure à instrumenter, et qui puisse être utilisé dans des conditions environnementales sévères.

Ce but est atteint dans le cadre de la présente invention grâce à un dispositif d'acquisition de données comprenant :
- un boîtier comprenant une paroi latérale délimitant une cavité,
- une pluralité de modules électroniques propres à être empilés dans la cavité selon une direction d'empilement,
   chaque module électronique présentant une première face et une deuxième face opposée à la première face, et comprenant un premier ensemble de pistes conductrices s'étendant sur la première face, et un deuxième ensemble de pistes conductrices s'étendant sur la deuxième face, le premier ensemble de pistes conductrices comprenant au moins une piste conductrice dédiée à la transmission d'un signal de données, et le deuxième ensemble de pistes conductrices comprenant au moins une piste conductrice dédiée à la transmission du signal de données et reliée électriquement à la piste conductrice dédiée à la transmission du signal de données du premier ensemble de pistes conductrices via un passage de connexion électrique s'étendant à l'intérieur du module électronique,
- un ou plusieurs bloc(s) de connexion, chaque bloc de connexion étant disposé entre deux modules électroniques adjacents de l'empilement pour établir une connexion électrique entre chaque piste du premier ensemble de pistes conductrices de l'un des modules électroniques et une piste correspondante du deuxième ensemble de pistes de l'autre des modules électroniques, et
- un organe de pressage propre à appliquer une force de compression sur les modules électroniques, parallèlement à la direction d'empilement, la force de compression tendant à déformer chaque bloc de connexion en augmentant une dimension du bloc de connexion dans une direction radiale, perpendiculaire à la direction d'empilement, de sorte à maintenir chaque bloc de connexion en appui contre la paroi latérale du boîtier.

Dans un tel dispositif, la transmission de données entre les différents modules électroniques est réalisée grâce aux pistes conductrices dédiées présentes sur les faces de chaque module. Ainsi, le raccordement électrique d'un module électronique de l'empilement est assuré par les autres modules, et non grâce à une carte électronique ou à un câblage spécifique.

Comme le ou les bloc(s) de connexion est(sont) maintenu(s) en appui contre la paroi latérale, le ou les bloc(s) de connexion immobilise(nt) les modules électroniques dans le boîtier. Les modules électroniques sont ainsi protégés contre les vibrations et les chocs. De ce fait, le dispositif d'acquisition peut être utilisé pour l'acquisition de données dans des conditions environnementales sévères.

Dans un mode de réalisation de l'invention, les pistes conductrices sont agencées de sorte que lorsque les modules électroniques sont empilés dans la cavité, quel que soit l'ordre d'empilement des modules électroniques dans la cavité, la piste conductrice dédiée à la transmission du signal de donnée sur la deuxième face de l'un des modules fait face à la piste conductrice dédiée à la transmission du signal de données de la première face d'un autre module adjacent dans l'empilement, pour propager le signal de données d'un module à l'autre à travers la totalité de l'empilement.

Comme les modules électroniques peuvent être empilés dans le boîtier dans n'importe quel ordre, sans que leurs fonctions ne soient modifiées, il est possible de reconfigurer facilement le dispositif : il suffit simplement d'ajouter et/ou de retirer un ou plusieurs module(s) électronique(s) en fonction des besoins.

Le dispositif proposé peut en outre présenter l'une des caractéristiques suivantes :
- au moins l'un des modules électroniques est propre à générer le signal de données,
- le premier ensemble de pistes conductrices comprend au moins une piste conductrice dédiée à la transmission d'un signal de synchronisation, et le deuxième ensemble de pistes conductrices comprend au moins une piste conductrice dédiée à la transmission du signal de synchronisation et reliée électriquement à la piste conductrice dédiée à la transmission du signal de synchronisation du deuxième ensemble de pistes via un passage de connexion électrique s'étendant à l'intérieur du module électronique, les pistes étant agencées de sorte que lorsque les modules électroniques sont empilés dans la cavité, la piste conductrice dédiée à la transmission du signal de synchronisation sur la deuxième face de l'un des modules fait face à la piste conductrice dédiée à la transmission du signal de synchronisation sur la première face d'un autre des modules,
- le premier ensemble de pistes conductrices comprend au moins une piste conductrice dédiée à la transmission d'un signal d'alimentation, et le deuxième ensemble de pistes conductrices comprend au moins une piste conductrice dédiée à la transmission du signal d'alimentation et reliée électriquement à la piste conductrice dédiée à la transmission du signal d'alimentation du deuxième ensemble de pistes via un passage de connexion électrique s'étendant à l'intérieur du module électronique, les pistes étant agencées de sorte que lorsque les modules électroniques sont empilés dans la cavité, la piste conductrice dédiée à la transmission du signal d'alimentation sur la deuxième face de l'un des modules fait face à la piste conductrice dédiée à la transmission du signal d'alimentation sur la première face d'un autre des modules,
- le premier ensemble de pistes conductrices comprend au moins une piste conductrice dédiée à la transmission du signal de données, une piste conductrice dédiée à la transmission du signal de synchronisation et une piste conductrice dédiée à la transmission du signal d'alimentation, et le deuxième ensemble de pistes conductrices au moins une piste conductrice dédiée à la transmission du signal de données, une piste conductrice dédiée à la transmission du signal de synchronisation et une piste conductrice dédiée à la transmission du signal d'alimentation, reliées électriquement respectivement à la piste conductrice dédiée à la transmission du signal de données, à la piste conductrice dédiée à la transmission du signal de synchronisation et à la piste conductrice dédiée à la transmission du signal d'alimentation du premier ensemble de pistes conductrices, via des passages de connexion électrique s'étendant à l'intérieur du module électronique depuis la première face jusqu'à la deuxième face,
- l'organe de pressage comprend un élément élastique de rappel, tel qu'un ressort de compression par exemple,
- le dispositif d'acquisition comprend une première plaque d'extrémité, l'organe de pressage étant disposé entre le corps du capuchon et la première plaque d'extrémité, de sorte que l'organe de pressage applique la force de compression sur les modules électroniques via la première plaque d'extrémité,
- le dispositif d'acquisition comprend une deuxième plaque d'extrémité, et les modules électroniques sont disposés entre la première plaque d'extrémité et la deuxième plaque d'extrémité,
- le boîtier présente une ouverture, le dispositif d'acquisition comprenant en outre :
   un capuchon comprenant un corps propre à obturer l'ouverture du boîtier, et
   un connecteur s'étendant à travers le corps du capuchon, le connecteur étant propre à être raccordé à un câble de communication, pour transmettre le signal de données entre l'un ou plusieurs des modules électroniques disposés à l'intérieur de la cavité et un équipement distant situé à l'extérieur du boîtier,
- le dispositif d'acquisition comprend une première plaque d'extrémité disposée entre le capuchon et l'empilement, et la première plaque d'extrémité présente une troisième face et comprend un troisième ensemble de pistes conductrices s'étendant sur la troisième face, les pistes du troisième ensemble de pistes conductrices étant d'une part raccordées électriquement au connecteur et étant propres d'autre part à être raccordées électriquement aux pistes du premier ensemble de pistes conductrice ou du deuxième ensemble de pistes conductrices de l'un des modules électroniques,
- le dispositif d'acquisition comprend un cordon de raccordement électrique souple raccordant les pistes du troisième ensemble de pistes conductrices au connecteur,
- chaque bloc de connexion est formé en un matériau électriquement conducteur anisotropique présentant une conductivité électrique élevée (c'est-à-dire une résistance électrique faible, typiquement inférieure à 1 Ohm, par exemple quelques milliohms) selon une première direction parallèle à une direction d'empilement des modules électroniques et une conductivité électrique faible (c'est-à-dire une résistance électrique élevée, typiquement supérieure à 10⁹ Ohms, par exemple de l'ordre de quelques Gigaohms) selon une direction perpendiculaires à la direction d'empilement des modules électroniques, de manière à établir la connexion électrique entre chaque piste du premier ensemble de pistes conductrice de l'un des modules électroniques et une piste correspondante du deuxième ensemble de pistes de l'autre des modules électroniques,
- le matériau électriquement conducteur anisotropique comprend une matrice non-conductrice et une pluralité d'éléments électriquement conducteurs dispersés dans la matrice, les éléments électriquement conducteurs étant aptes à conduire des signaux électriques selon la première direction uniquement,
- la matrice est formée en un matériau élastomère,
- chaque module électronique comprend une première carte électronique présentant la première face sur laquelle s'étend le premier ensemble de pistes conductrices, une deuxième carte électronique présentant la deuxième face sur laquelle s'étend le deuxième ensemble de pistes conductrices, et un ou plusieurs composant(s) électronique(s) disposé(s) entre la première carte électronique et la deuxième carte électronique et raccordés à l'une des pistes du premier ensemble de pistes conductrices et à l'une des pistes du deuxième ensemble de pistes conductrices,
- l'un des composants électroniques est propre à recevoir un signal électrique d'entrée contenant des données de mesure via la piste du premier ensemble de pistes conductrices à laquelle le composant électronique est raccordé, à appliquer un traitement aux données de mesure, et à générer un signal électrique de sortie contenant les données de mesure traitées via la piste du deuxième ensemble de pistes conductrices à laquelle le composant électronique est raccordé,
- l'un des composants électroniques est une batterie propre à générer une tension entre la piste du premier ensemble de pistes conductrices à laquelle le composant électronique est raccordé et la piste du deuxième ensemble de pistes conductrices à laquelle le composant électronique est raccordé,
- l'un des composants électroniques est un capteur propre à générer un signal électrique de mesure contenant des données de mesure, tels que par exemple un capteur de vibration, un capteur d'accélération, un capteur acoustique, un capteur de température ou un capteur de pression,
- chaque module électronique comprend un matériau d'enrobage remplissant l'espace entre les composants et les cartes électroniques,
- chaque module comprend des parois latérales s'étendant entre la première carte électronique et la deuxième carte électronique, de manière à délimiter avec la première carte électronique et la deuxième carte électronique une enceinte de protection contenant le ou les composant(s) électronique,
- les pistes du premier ensemble de pistes conductrices et du deuxième ensemble de pistes conductrices sont circulaires et disposées de manière concentriques,
- le boîtier comprend une paroi latérale de forme cylindrique de révolution entourant la cavité.

L'invention se rapporte également à un système d'acquisition de données, comprenant :
une pluralité de dispositifs d'acquisition tels que définis précédemment, propres à être fixées en différents endroits d'une structure à instrumenter, et
un concentrateur de données propre à être raccordé aux différents dispositifs d'acquisition via des câbles de communication ou via des liaisons sans fil pour recevoir des signaux de données de mesure en provenance des différents dispositifs d'acquisition.

Dans un mode de réalisation de l'invention, le système d'acquisition comprend en outre une pluralité de capteurs propres à être fixés à la structure à instrumenter, chaque capteur étant relié à l'un des dispositifs d'acquisition pour transmettre des données de mesure au dispositif d'acquisition.

### PRESENTATION DES DESSINS

D'autres caractéristiques et avantages ressortiront encore de la description qui suit, laquelle est purement illustrative et non limitative, et doit être lue en regard des figures annexées, parmi lesquelles :
- la figure 1 déjà commentée représente de manière schématique un premier exemple de dispositif d'acquisition de données de l'état de la technique,
- la figure 2 déjà commentée représente de manière schématique un deuxième exemple de dispositif d'acquisition de données de l'état de la technique,
- la figure 3 représente de manière schématique un dispositif d'acquisition de données, conforme à un mode de réalisation possible de l'invention,
- la figure 4 représente de manière schématique un capuchon du dispositif d'acquisition,
- la figure 5 représente de manière schématique, en vue en coupe, un module électronique faisant partie du dispositif d'acquisition de données,
- la figure 6 représente de manière schématique, une première face d'un module électronique,
- la figure 7 représente de manière schématique, une deuxième face du module électronique,
- la figure 8 représente de manière schématique, un bloc de connexion disposé entre deux modules électroniques adjacents,
- la figure 9 représente de manière schématique un autre bloc de connexion disposé entre deux modules électroniques adjacents,
- les figures 10 à 14 représentent de manière schématique différentes fonctions pouvant être assurées par un module électronique,
- les figures 15 à 18 représentent de manière schématique différentes fonctions pouvant être assurées par un ensemble d'extrémité incluant un capuchon du dispositif d'acquisition,
- la figure 19 représente de manière schématique un système d'acquisition de données comprenant une pluralité de dispositifs d'acquisition.

### DESCRIPTION DETAILLEE D'UN MODE DE REALISATION

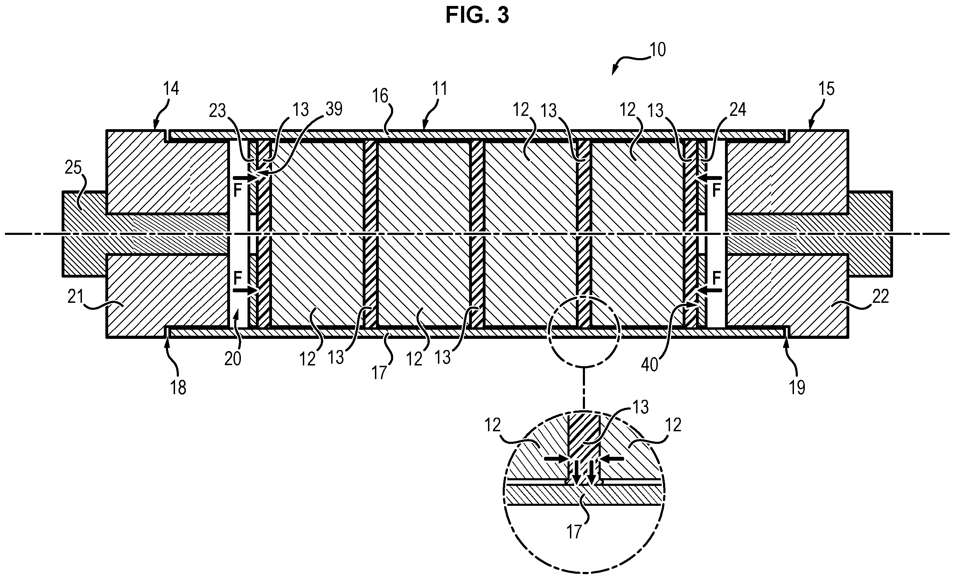

Sur la figure 3, le dispositif d'acquisition de données 10 représenté comprend un boîtier 11, une pluralité de modules électroniques 12 et une pluralité de blocs de connexion 13.

Le boîtier 11 comprend deux capuchons d'extrémité 14, 15 et un corps 16. Le corps 16 comprend une paroi latérale 17 de forme générale cylindrique, par exemple cylindrique de révolution, ayant un axe X. La paroi latérale 17 présente deux bords libres 18, 19 délimitant deux ouvertures d'extrémité. Chaque capuchon 14, 15 est propre à être introduit dans l'une des ouvertures et à être fixé au corps 16, par exemple par vissage ou par tout autre moyen. La paroi latérale 17 délimite une cavité 20 propre à recevoir les modules électroniques 12 et les blocs de connexion 13. La cavité 20 s'étend entre les deux ouvertures du boîtier 11.

Les modules électroniques 12 et les blocs de connexion 13 sont propres à être introduits à l'intérieur de la cavité 20 du boîtier via l'une des ouvertures. De plus, les modules électroniques 12 et les blocs de connexion 13 sont propres à être empilés dans la cavité 20 selon une direction d'empilement parallèle à l'axe X du boîtier 11. Plus précisément, les modules électroniques 12 et les blocs de connexion 13 sont empilés en alternance les uns avec les autres de sorte que chaque module électronique 12 se trouve entre deux blocs de connexion 13 dans l'empilement.

Chaque module électronique 12 est propre à assurer une fonction qui lui est propre. Par exemple, les modules électroniques peuvent inclure un ou plusieurs capteur(s) (tel qu'un accéléromètre ou un capteur de pression par exemple), des composants de traitement de données, un mémoire et une batterie.

Les modules électroniques 12 peuvent également inclure un module intercalaire, i.e. un module électronique qui ne remplit aucune fonction spécifique, mais qui sert à compléter l'empilement, dans le cas où la cavité 20 présente un volume prédéterminé et où le nombre de modules électroniques 12 nécessaires ne permet pas de combler entièrement l'espace de la cavité 20.

Chaque capuchon 14, 15 comprend une pièce d'obturation 21, 22 propre à être fixée sur le corps 16 pour fermer l'une des ouvertures et une plaque d'extrémité 23, 24.

Une fois les capuchons 14, 15 fixés sur le corps 16, l'empilement constitué des modules électriques 12 et des blocs de connexion 13 se trouve entre les deux plaques d'extrémité 23 et 24.

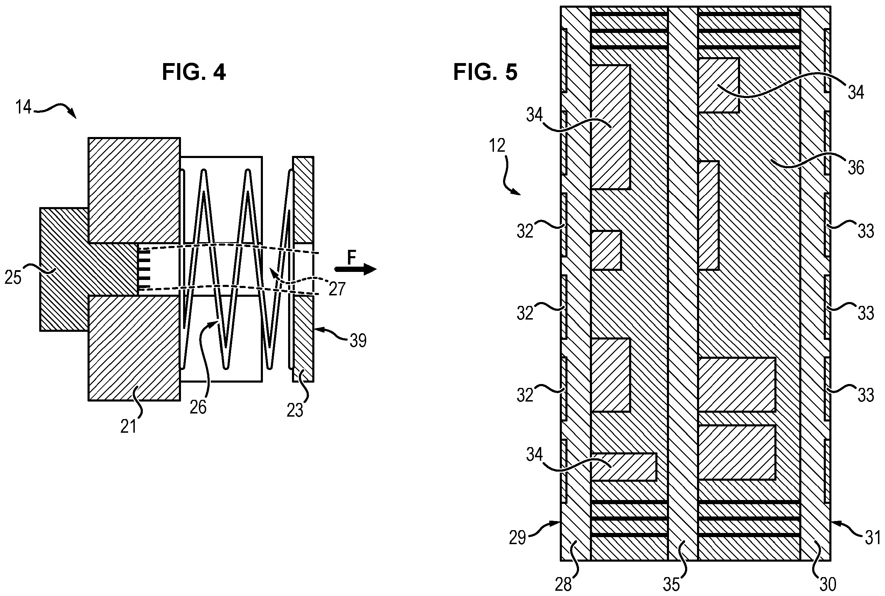

Comme illustré sur la figure 4, le capuchon 14 comprend un connecteur 25 s'étendant à travers la pièce d'obturation 21 et un organe de pressage 26.

L'organe de pressage 26 est disposé entre la pièce d'obturation 21 et la plaque d'extrémité 23 du capuchon 14. L'organe de pressage 26 est propre à appliquer une force de compression F sur l'empilement, parallèlement à la direction d'empilement pour maintenir les modules électroniques 12 et les blocs de connexion 13 en compression les uns contre les autres. L'organe de pressage 26 applique la force de compression F sur les modules électroniques 12 via la plaque d'extrémité 23.

Comme illustré sur la figure 4, l'organe de pressage 26 peut comprendre un élément élastique de rappel, tel qu'un ressort de compression par exemple.

Le capuchon 14 comprend en outre un cordon de raccordement électrique souple 27 raccordant des pistes conductrices de la plaque d'extrémité 23 au connecteur 25.

Le connecteur 25 est propre à être raccordé à un câble de communication, pour transmettre des signaux entre l'un ou plusieurs des modules électroniques 12 disposés à l'intérieur de la cavité 20 et un équipement distant situé à l'extérieur du boîtier 11.

Les figures 5 à 7 représentent de manière schématique un module électronique 12. Le module électronique 12 présente une forme de pastille cylindrique.

Dans l'exemple illustré sur la figure 5, le module électronique 12 comprend une première carte électronique 28 présentant une première face plane 29 et une deuxième carte électronique 30 présentant une deuxième face plane 31, opposée à la première face plane 29. Les faces planes 29 et 31 s'étendent perpendiculairement à la direction d'empilement. Le module électronique 12 comprend en outre un premier ensemble de pistes conductrices 32 s'étendant sur la première face 29, et un deuxième ensemble de pistes conductrices 33 s'étendant sur la deuxième face 31.

Le module électronique 12 comprend également une pluralité de connexions électriques 42 disposées entre les deux cartes électroniques 28 et 30 et s'étendant chacune depuis la première face 29 jusqu'à la deuxième face 31 de manière à relier les pistes 32 et 33 deux à deux. Le module électronique 12 comprend en outre une pluralité de composants électroniques 34 disposés entre les deux cartes électroniques 28 et 30 et raccordés à certaines des connexions électriques 42. Le module électronique 12 peut en outre comprendre une ou plusieurs cartes intermédiaires 35 disposée(s) entre les première carte électronique 28 et la deuxième carte électronique 30, et supportant les composants électroniques 34. Le module électronique 12 comprend en outre un matériau d'enrobage 36 remplissant l'espace entre les composants 34 et les cartes électroniques 28, 30, 35. De cette manière, les connexions électriques 42 et les composants électroniques 34 sont protégés des contraintes mécaniques (vibrations, choc, variations de pression) et de l'humidité ambiante par le matériau d'enrobage 36. Par ailleurs, le matériau d'enrobage 36 peut être choisi pour rendre le module électronique 12 étanche.

De manière alternative, chaque module 12 peut comprendre des parois latérales s'étendant entre la première carte électronique 28 et la deuxième carte électronique 30, de manière à délimiter avec la première carte électronique et la deuxième carte électronique une enceinte de protection contenant les connexions électriques 42 et le ou les composant(s) électronique 34.

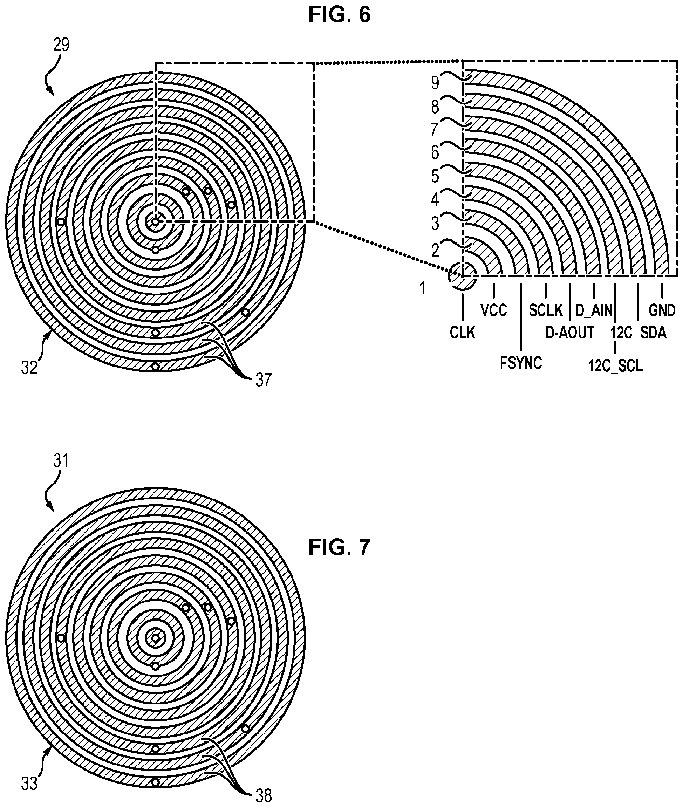

Comme illustré sur la figure 6, le premier ensemble de pistes conductrices 32 comprend une pluralité de pistes conductrices circulaires 37 agencées de manière concentrique selon un premier motif.

Comme illustré sur la figure 7, le deuxième ensemble de pistes conductrices 33 comprend une pluralité de pistes conductrices circulaires 38 agencées de manière concentrique selon un deuxième motif. Le deuxième motif est identique au premier motif.

Le premier ensemble de piste 32 est identique d'un module électronique 12 à l'autre. De même, le deuxième ensemble de pistes 33 est identique d'un module électronique 12 à l'autre.

En outre, dans l'exemple illustré sur les figures 6 et 7, le premier ensemble de piste 32 est symétrique du deuxième ensemble de pistes 33. Plus précisément, dans cet exemple, le premier ensemble de piste 32 est identique au deuxième ensemble de pistes 33

Chacun du premier ensemble de pistes 32 et du deuxième ensemble de pistes 33 peut comprendre entre 3 et 10 pistes.

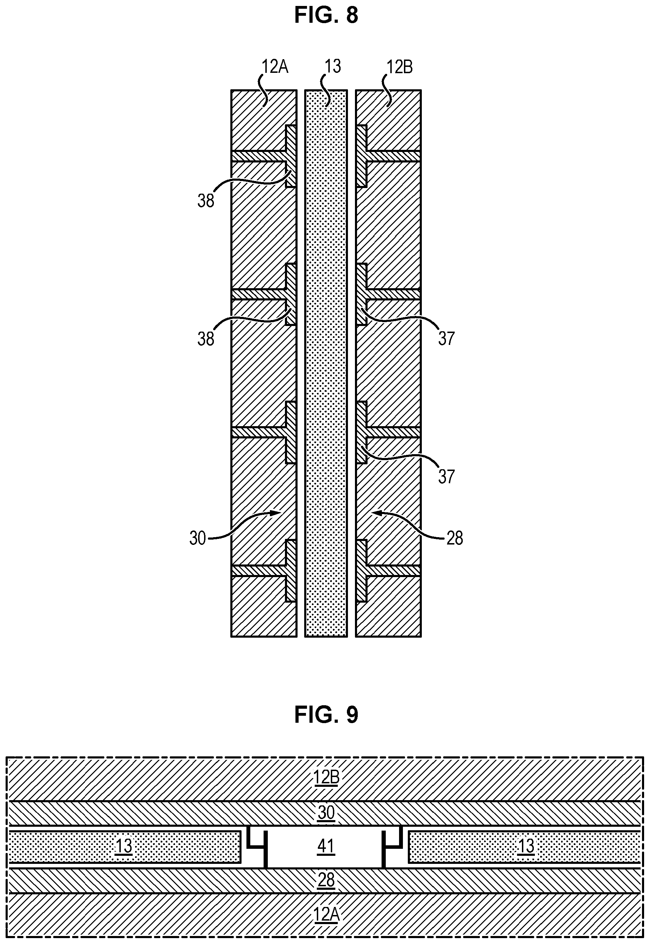

Dans l'exemple illustré sur les figures 7 et 8, le premier ensemble de pistes 32 et le deuxième ensemble de pistes 33 comprennent chacun 9 pistes distinctes, numérotées de 1 à 9. Chaque piste est dédiée à la transmission d'un signal prédéterminé.

Dans l'exemple illustré sur les figures 6 et 7, les pistes n°1 et n°3 sont dédiées à la transmission de signaux de synchronisation (appelés « CLK » et « FSYNC »), les pistes n°2 et 9 sont dédiées à la transmission de signaux d'alimentation (appelés « VCC » et « GND ») et les pistes n°4 à 8 sont dédiées à la transmission de signaux de données (appelés « SCLK », « D_AOUT », « D_AIN », « I2C_SCL », « I2C_SDA »).

Les pistes conductrices 37 et 38 sont ainsi agencées de sorte que lorsque les modules électroniques 12 sont empilés dans la cavité 20, chacune des pistes conductrices n°1 à 9 de la deuxième face 31 d'un module électronique fait face à une piste conductrices n°1 à 9 correspondante de la première face 29 d'un module électronique adjacent dans l'empilement. De cette manière, les signaux sont propagés d'un module électronique 12 à l'autre à travers l'empilement, quel que soit l'ordre d'empilement des modules électroniques 12 dans la cavité 20.

Par ailleurs, la première plaque d'extrémité 23 présente une première face d'appui 39 dirigée vers l'empilement. La première plaque d'extrémité 23 comprend un troisième ensemble de pistes conductrices s'étendant sur la première face d'appui 39. Le troisième ensemble de pistes conductrices est identique au deuxième ensemble de pistes conductrices 33 illustré sur la figure 7. Le cordon de raccordement électrique souple 27 raccorde les pistes du troisième ensemble de pistes conductrices au connecteur 25. Les pistes conductrices sont ainsi agencées de sorte que lorsque les modules électroniques 12 sont empilés dans la cavité 20, chacune des pistes conductrices n°1 à 9 de la première face 29 du module électronique 12 situé à la première extrémité de l'empilement fait face à une piste conductrices n°1 à 9 correspondante de la première face d'appui 39 de la première plaque d'extrémité 23. Ainsi, les pistes du troisième ensemble de pistes conductrices sont d'une part raccordées électriquement au connecteur 25 et d'autre part raccordées aux pistes 37 du premier ensemble de pistes conductrice 32 du module électronique 12 situé à la première extrémité de l'empilement.

De même la deuxième plaque d'extrémité 24 présente une deuxième face d'appui 40 dirigée vers l'empilement. La deuxième plaque d'extrémité 24 comprend un quatrième ensemble de pistes conductrices s'étendant sur la deuxième face d'appui 40. Le quatrième ensemble de pistes conductrices est identique au premier ensemble de pistes conductrices 32. Les pistes conductrices sont ainsi agencées de sorte que lorsque les modules électroniques 12 sont empilés dans la cavité 20, chacune des pistes conductrices n°1 à 9 de la deuxième face 31 du module électronique 12 situé à la deuxième extrémité de l'empilement fait face à une piste conductrices n°1 à 9 correspondante de la deuxième face d'appui 40. Les pistes du quatrième ensemble de pistes conductrices sont ainsi raccordées aux pistes 38 du deuxième ensemble de pistes conductrices 33 du module électronique 12 situé à la deuxième extrémité de l'empilement, opposée à la première extrémité de l'empilement.

Comme illustré sur la figure 8, chaque bloc de connexion 13 présente la forme d'un disque et est propre à être disposé entre deux modules électroniques 12 adjacents de l'empilement. Plus précisément, le bloc de connexion 13 illustré sur la figure 8 est disposé entre une deuxième face 31 d'un premier module électronique 12A et une première face 29 d'un deuxième module électronique 12B disposée en regard de la deuxième face 31. Le bloc de connexion est propre à établir une connexion électrique entre chaque piste 37 du premier ensemble de pistes conductrices 32 du premier module électronique 12A et une piste 38 correspondante du deuxième ensemble de pistes 33 du deuxième module électronique 12B.

Chaque bloc de connexion 13 est formé en un matériau électriquement conducteur anisotropique présentant une conductivité électrique élevée (c'est-à-dire une résistance faible, par exemple de l'ordre de 1 ohm) selon une première direction parallèle à la direction d'empilement des modules électroniques 12 (c'est-à-dire parallèle à la direction de l'axe X) et une conductivité électrique faible (c'est-à-dire une résistance élevée, par exemple de l'ordre de 10¹² ohms) selon une direction perpendiculaires à la direction d'empilement des modules électroniques 12, de manière à établir une connexion électrique entre chaque piste 37 du premier ensemble de pistes conductrices 32 du module électronique 12B et une piste 38 correspondante du deuxième ensemble de pistes 33 du module électronique 12A.

Le matériau électriquement conducteur anisotropique peut comprendre une matrice électriquement non-conductrice, formée par exemple en un matériau élastomère, et une pluralité d'éléments électriquement conducteurs dispersés dans la matrice, les éléments électriquement conducteurs étant aptes à conduire des signaux électriques selon la direction d'empilement uniquement.

Lorsqu'ils sont soumis à une force de compression, les blocs de connexion 13 ont tendance à se déformer. Plus précisément, l'épaisseur du bloc de connexion 13 mesurée selon la direction d'empilement tend à diminuer, tandis que le rayon du bloc de connexion 13, mesuré selon une direction radiale, perpendiculaire à la direction d'empilement, tend à augmenter. Les blocs de connexion 13 occupent ainsi l'espace entre les modules électroniques 13 et les plaques d'extrémité 23 et 24, et viennent en appui contre la paroi latérale 17 du boîtier 11. De cette manière, les blocs de connexion 13 immobilisent les modules électroniques 12 dans le boîtier 11, protègent les modules électroniques 12 contre les vibrations et les chocs.

Chaque bloc de connexion 13 présente une surface externe annulaire. Comme illustré sur la figure 3, chaque bloc de connexion 13 est dimensionné de sorte que, sous l'effet de la force de compression F, le bloc de connexion 13 subit une expansion radiale. Cela a pour conséquence que la surface externe annulaire du bloc de connexion 13 est pressée contre la surface interne cylindrique de la paroi latérale 17. Le matériau du bloc de connexion 13 est écrasé contre la surface interne de la paroi latérale 17. De cette manière, les blocs de connexion 13 séparent les modules électroniques 13 de manière étanche. Les modules électroniques 13 sont ainsi protégés de l'humidité ou de la pénétration de contaminants à l'intérieur de la cavité 20.

Par ailleurs, les blocs de connexion 13 peuvent être formés en un matériau permettant de conduire la chaleur pouvant être générée par les modules électroniques 12 vers la paroi latérale du boîtier, afin de dissiper la chaleur vers l'extérieur. Afin d'améliorer encore la dissipation de chaleur, le boîtier 11 peut comprendre des ailettes agencées sur la surface externe de la paroi latérale 17.

La figure 9 représente de manière schématique un autre exemple de bloc de connexion 13 pouvant être disposé entre deux modules électroniques 12 adjacents. Le bloc de connexion 13 présente une forme annulaire. Le dispositif d'acquisition comprend en outre un connecteur 41 disposé au centre du bloc de connexion 13.

Du fait de la disposition des pistes conductrices 37 et 38 sur les faces des modules électroniques 12, les signaux électriques tels que les signaux de synchronisation, les signaux d'alimentation et les signaux de données sont transmis d'un module 12 à l'autre à travers l'empilement, et ce quel que soit l'ordre des modules électroniques 12 dans l'empilement.

Chaque module électronique 12 peut propager les signaux de données, les signaux de synchronisation ou les signaux d'alimentation de la manière suivante :
- le module électronique 12 transmet le signal entre une piste 37 du premier ensemble de pistes conductrices 32 et une piste correspondante 38 du deuxième ensemble de pistes conductrices 33, sans utiliser ni traiter le signal,
- le module électronique 12 transmet le signal entre une piste 37 du premier ensemble de pistes conductrices 32 et une piste correspondante 38 du deuxième ensemble de pistes conductrices 33, et en même temps, utilise le signal pour faire fonctionner ses composants électroniques.

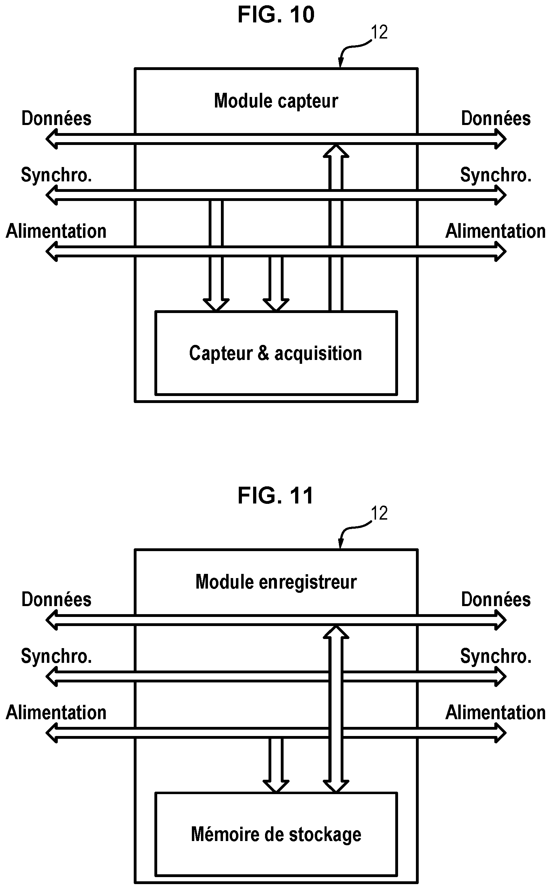

Les figures 10 à 14 représentent de manière schématique différents exemples de fonctions pouvant être assurées par un module électronique 12.

Sur la figure 10, le module électronique 12 est un module de capteur.

Le module électronique comprend un capteur propre à générer un signal de données incluant des données de mesure (par exemple un accéléromètre ou un capteur de pression). Le module électronique transmet le signal de données entre une piste du premier ensemble de pistes conductrices et une piste correspondante du deuxième ensemble de pistes conductrices. Le module électronique utilise un signal de synchronisation pour synchroniser ses composants électroniques qui le nécessitent (typiquement les composants de conversion analogique/numérique), tout en transmettant le signal de synchronisation entre une piste du premier ensemble de pistes conductrices et une piste correspondante du deuxième ensemble de pistes conductrices. De même, le module électronique utilise un signal de puissance pour alimenter ses composants électroniques, tout en transmettant le signal de puissance entre une piste du premier ensemble de pistes conductrices et une piste correspondante du deuxième ensemble de pistes conductrices.

Sur la figure 11, le module électronique 12 est un module d'enregistrement de données.

Le module électronique comprend une mémoire configurée pour enregistrer des données à partir du signal de données. Le module électronique transmet le signal de données entre une piste du premier ensemble de pistes conductrices et une piste correspondante du deuxième ensemble de pistes conductrices. Le module électronique utilise le signal de puissance pour alimenter ses composants électroniques, tout en transmettant le signal de puissance entre une piste du premier ensemble de pistes conductrices et une piste correspondante du deuxième ensemble de pistes conductrices. De plus, le module électronique transmet le signal de synchronisation entre une piste du premier ensemble de pistes conductrices et une piste correspondante du deuxième ensemble de pistes conductrices, sans utiliser ni traiter le signal.

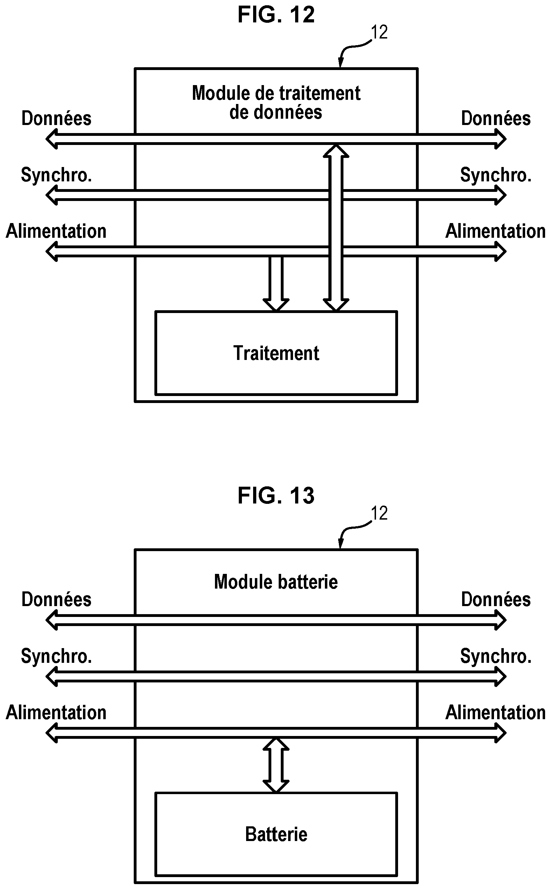

Sur la figure 12, le module électronique 12 est un module de traitement.

Le module électronique est configuré pour traiter le signal de données qu'il reçoit et pour générer un signal de données traité. Le module électronique utilise le signal de puissance et le signal de synchronisation pour alimenter ses composants électroniques, tout en transmettant le signal de puissance et le signal de synchronisation entre des pistes du premier ensemble de pistes conductrices et des pistes correspondantes du deuxième ensemble de pistes conductrices.

Sur la figure 13, le module électronique 12 est un module d'alimentation, dont l'un des composants électroniques est une batterie.

Le module électronique est configuré pour générer un signal d'alimentation. Le module électronique transmet le signal de données entre une piste du premier ensemble de pistes conductrices et une piste correspondante du deuxième ensemble de pistes conductrices, sans utiliser ni traiter le signal. De même, le module électronique transmet le signal de synchronisation entre une piste du premier ensemble de pistes conductrices et une piste correspondante du deuxième ensemble de pistes conductrices, sans utiliser ni traiter le signal.

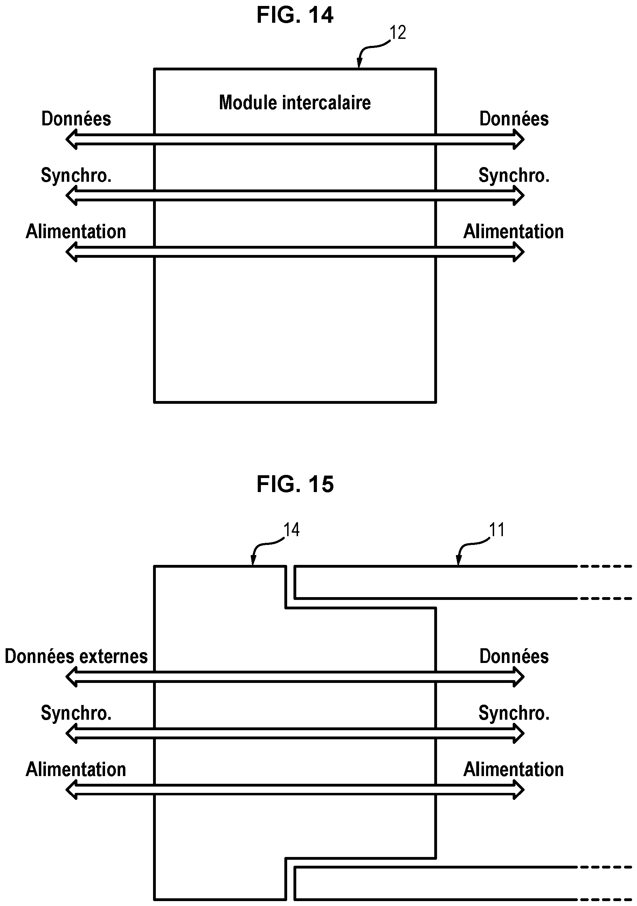

Sur la figure 14, le module électronique 12 est un module intercalaire.

Dans ce cas, le module électronique ne remplit aucune fonction spécifique, à part adapter la taille totale de l'empilement à une dimension souhaitée. Le module électronique transmet le signal de données, le signal de synchronisation et le signal de puissance entre une piste respective du premier ensemble de pistes conductrices et une piste respective correspondante du deuxième ensemble de pistes conductrices, sans utiliser ni traiter le signal.

Les figures 15 à 18 représentent de manière schématique différentes fonctions pouvant être assurées par l'un des capuchons 14 ou 15.

Sur la figure 15, le capuchon 14 est un capuchon passif, c'est-à-dire qu'il ne remplit aucune fonction spécifique.

Dans ce cas, les pistes du troisième ensemble de pistes conductrices sont raccordées électriquement au connecteur. Ainsi, le connecteur reçoit le signal de données, le signal de synchronisation et le signal d'alimentation. Ces signaux peuvent être transmis via un câble de communication ou une connexion sans fil vers un équipement distant situé à l'extérieur du boîtier du dispositif.

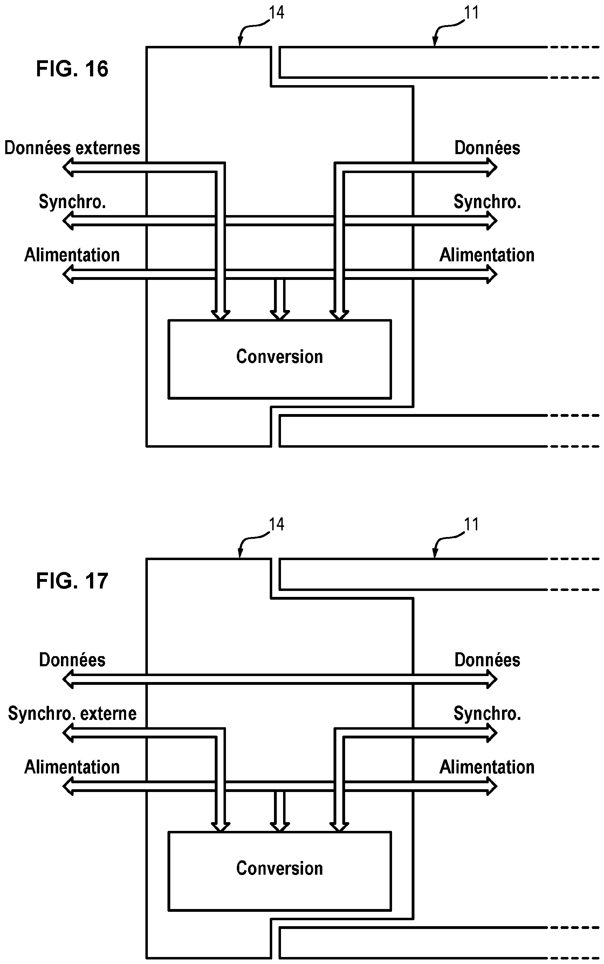

Les figures 16 à 18 illustrent des modes de réalisation du capuchon, dans lequel le capuchon est actif, c'est-à-dire qu'il remplit une fonction qui lui est propre.

Sur la figure 16, le capuchon 14 inclut un composant de conversion, propre à convertir le signal de données qui se propage à travers les différents modules de l'empilement sous un premier format en un signal de données présentant un deuxième format, différent du premier format. Le signal de données sous le deuxième format est propre à être diffusé sur un câble de communication ou via une connexion sans fil vers un équipement distant situé à l'extérieur du boîtier du dispositif. Le composant de conversion est également apte à réaliser une conversion inverse, c'est-à-dire à convertir un signal de données sous le deuxième format en un signal de données sous le premier format.

Sur la figure 17, le capuchon 14 inclut un composant de conversion, propre à convertir le signal de synchronisation qui se propage à travers les différents modules de l'empilement sous un premier format en un signal de synchronisation présentant un deuxième format, différent du premier format. Le signal de synchronisation sous le deuxième format est propre à être diffusé sur un câble de communication ou via une connexion sans fil vers un équipement distant situé à l'extérieur du boîtier du dispositif. Le composant de conversion est également apte à réaliser une conversion inverse, c'est-à-dire à convertir un signal de synchronisation sous le deuxième format en un signal de synchronisation sous le premier format.

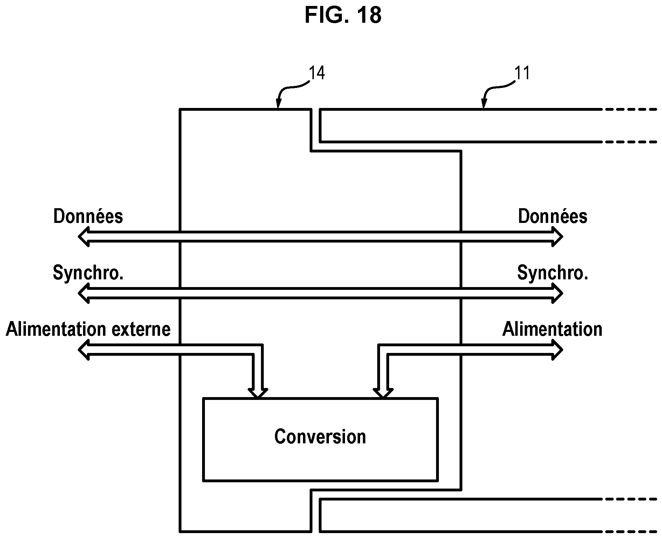

Sur la figure 18, le capuchon 14 inclut un composant de conversion, propre à convertir le signal d'alimentation qui se propage à travers les différents modules de l'empilement sous un premier format (par exemple un premier niveau de tension) en un signal d'alimentation présentant un deuxième format (par exemple un deuxième niveau de tension), différent du premier format. Le signal d'alimentation sous le deuxième format est propre à être diffusé sur un câble de communication vers un équipement distant situé à l'extérieur du boîtier du dispositif. Le composant de conversion est également apte à réaliser une conversion inverse, c'est-à-dire à convertir un signal d'alimentation sous le deuxième format en un signal d'alimentation sous le premier format.

Un capuchon remplissant plusieurs parmi les trois fonctions illustrées sur les figures 16 à 18 pourrait bien entendu être envisagé.

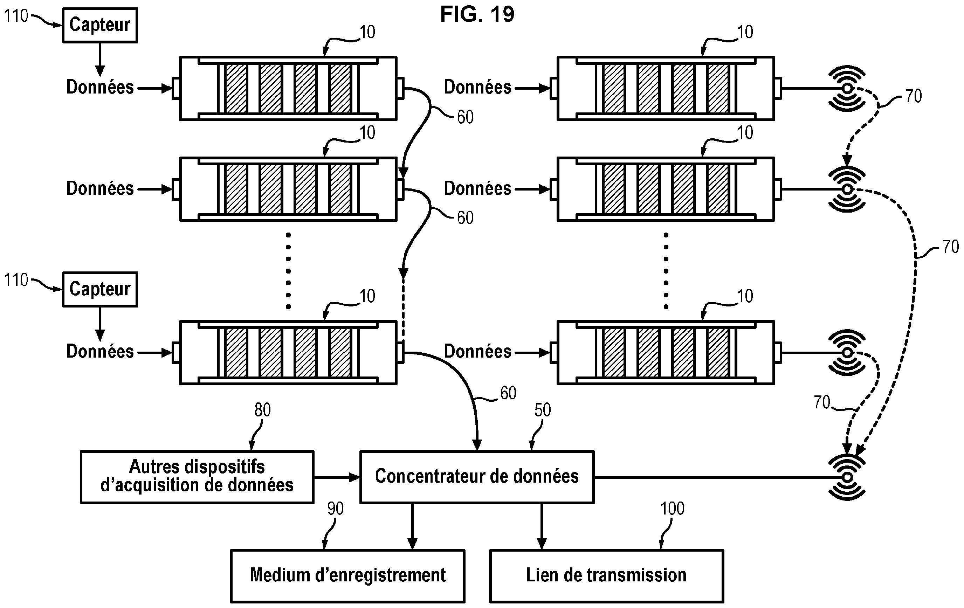

La figure 19 représente de manière schématique un système d'acquisition de données.

Le système d'acquisition de données représenté comprend une pluralité de dispositifs d'acquisition de données 10 et un concentrateur de données 50.

Le système d'acquisition de données comprend une pluralité de capteurs fixés en différentes positions à une structure à instrumenter. Parmi les capteurs, certains capteurs peuvent être des capteurs séparés 110, distincts des dispositifs d'acquisition de données 10. Dans ce cas, chaque capteur 110 est fixé à la structure à instrumenter et est relié un dispositif d'acquisition de données 10 associé. Le capteur 110 est relié au dispositif d'acquisition associé via un câble de communication ou une liaison sans fil afin de transmettre des données de mesure générées par le capteur 110 au dispositif d'acquisition de données 10 associé. Parmi les capteurs, d'autres capteurs peuvent être intégrés dans des dispositifs d'acquisition de données 10. Dans ce cas, le capteur fait partie d'un module électronique du dispositif d'acquisition de données 10.

Les dispositifs d'acquisition de données 10 peuvent être fixés à la structure à instrumenter (par exemple à un toron de câble ou à une tubulure) de manière simple, au moyen de colliers de serrage ou de serre-câbles autobloquants (tels que des colliers de serrage en plastique couramment dénommés « tyraps » ou en métal), sans vis, ni perçage. Le montage et le démontage de chaque dispositif d'acquisition 10 peut être réalisé sans outil, ce qui autorise un réagencement de l'ensemble d'acquisition en fonction des besoins.

Chaque dispositif d'acquisition de données 10 est raccordé à un autre dispositif d'acquisition de données 10 ou au concentrateur de données 50 via un câble de communication 60 ou via une liaison sans fil 70 (par exemple une liaison radiofréquence).

Le concentrateur de données 50 peut également être raccordé à d'autres dispositifs d'acquisition de données 80.

Le concentrateur de données 50 est configuré pour recevoir des signaux de données en provenance des différents dispositifs d'acquisition 10 et 80 et pour procéder à l'agrégation (avec ses propres données acquises en local), au filtrage (c'est-à-dire à la sélection de données parmi les données qu'il reçoit), à l'enregistrement des données dans un médium d'enregistrement 90 et/ou à la transmission des données vers d'autres équipements, tels que par exemple une station au sol lorsque l'ensemble d'acquisition est installé à bord d'un aéronef, via un lien de transmission 100.

## Revendications

1. Dispositif d'acquisition de données (10) comprenant :
- un boîtier (11) comprenant une paroi latérale (17) délimitant une cavité (20),
- une pluralité de modules électroniques (12) empilés dans la cavité (20) selon une direction d'empilement,
chaque module électronique (12) présentant une première face (29) et une deuxième face (31) opposée à la première face, et comprenant un premier ensemble de pistes conductrices (32) s'étendant sur la première face (29), et un deuxième ensemble de pistes conductrices (33) s'étendant sur la deuxième face (31), le premier ensemble de pistes conductrices (32) comprenant au moins une piste conductrice (4-8) dédiée à la transmission d'un signal de données, et le deuxième ensemble de pistes conductrices (33) comprenant au moins une piste conductrice (4-8) dédiée à la transmission du signal de données et reliée électriquement à la piste conductrice (4-8) dédiée à la transmission du signal de données du premier ensemble de pistes conductrices (32) via un passage de connexion électrique s'étendant à l'intérieur du module électronique,
- un ou plusieurs bloc(s) de connexion (13), chaque bloc de connexion (13) étant disposé entre deux modules électroniques adjacents (12A, 12B) de l'empilement pour établir une connexion électrique entre chaque piste (37) du premier ensemble de pistes conductrices (32) de l'un des modules électroniques (12B) et une piste correspondante (38) du deuxième ensemble de pistes (33) de l'autre des modules électroniques (12A), et
- un organe de pressage (26) propre à appliquer une force de compression (F) sur les modules électroniques (12), parallèlement à la direction d'empilement, la force de compression tendant à déformer chaque bloc de connexion (13) en augmentant une dimension du bloc de connexion (13) dans une direction radiale, perpendiculaire à la direction d'empilement, de sorte à maintenir chaque bloc de connexion (13) en appui contre la paroi latérale (17) du boîtier (11).

2. Dispositif selon la revendication 1, dans lequel les pistes conductrices (4-8) sont agencées de sorte que lorsque les modules électroniques (12) sont empilés dans la cavité (20), quel que soit l'ordre d'empilement des modules électroniques (12) dans la cavité (20), la piste conductrice (4-8) dédiée à la transmission du signal de donnée sur la deuxième face (31) de l'un des modules (12A) fait face à la piste conductrice (4-8) dédiée à la transmission du signal de données de la première face (29) d'un autre module (12B) adjacent dans l'empilement, pour propager le signal de données d'un module à l'autre à travers la totalité de l'empilement.

3. Dispositif selon l'une des revendications 1 et 2, dans lequel au moins l'un des modules électroniques (12) est propre à générer le signal de données.

4. Dispositif d'acquisition de données selon l'une des revendications 1 à 3, dans lequel le premier ensemble de pistes conductrices (32) comprend au moins une piste conductrice (1, 3) dédiée à la transmission d'un signal de synchronisation, et le deuxième ensemble de piste conductrices (33) comprend au moins une piste conductrice (1, 3) dédiée à la transmission du signal de synchronisation et reliée électriquement à la piste conductrice (1, 3) dédiée à la transmission du signal de synchronisation du premier ensemble de pistes conductrices (32) via un passage de connexion électrique s'étendant à l'intérieur du module électronique, les pistes (1, 3) étant agencées de sorte que lorsque les modules électroniques (12) sont empilés dans la cavité (20), la piste conductrice (1, 3) dédiée à la transmission du signal de synchronisation sur la deuxième face (31) de l'un des modules (12A) fait face à la piste conductrice (1, 3) dédiée à la transmission du signal de synchronisation sur la première face (29) d'un autre des modules (12B).

5. Dispositif d'acquisition selon l'une des revendications 1 à 4, dans lequel le premier ensemble de pistes conductrices (32) comprend au moins une piste conductrice (2, 9) dédiée à la transmission d'un signal d'alimentation, et le deuxième ensemble de piste conductrices (33) comprend au moins une piste conductrice (2, 9) dédiée à la transmission du signal d'alimentation et reliée électriquement à la piste conductrice (2, 9) dédiée à la transmission du signal d'alimentation du premier ensemble de pistes conductrices (32) via un passage de connexion électrique s'étendant à l'intérieur du module électronique, les pistes (2, 9) étant agencées de sorte que lorsque les modules électroniques (12) sont empilés dans la cavité (20), la piste conductrice (2, 9) dédiée à la transmission du signal d'alimentation sur la deuxième face (31) de l'un des modules (12A) fait face à la piste conductrice (2, 9) dédiée à la transmission du signal d'alimentation de la première face (29) d'un autre des modules (12B).

6. Dispositif d'acquisition selon l'une des revendications 1 à 5, dans lequel le premier ensemble de pistes conductrices (32) comprend au moins une piste conductrice (4-8) dédiée à la transmission du signal de données, une piste conductrice (1, 3) dédiée à la transmission du signal de synchronisation et une piste conductrice (2, 9) dédiée à la transmission du signal d'alimentation, et le deuxième ensemble de pistes conductrices (33) comprend au moins une piste conductrice (4-8) dédiée à la transmission du signal de données, une piste conductrice (1, 3) dédiée à la transmission du signal de synchronisation et une piste conductrice (2, 9) dédiée à la transmission du signal d'alimentation, reliées électriquement respectivement à la piste conductrice (4-8) dédiée à la transmission du signal de données, à la piste conductrice (1, 3) dédiée à la transmission du signal de synchronisation et à la piste conductrice (2, 9) dédiée à la transmission du signal d'alimentation du premier ensemble de pistes conductrices (32), via des passages de connexion électrique s'étendant depuis la première face (29) jusqu'à la deuxième face (31) à l'intérieur du module électronique.

7. Dispositif d'acquisition de données selon l'une des revendications 1 à 6, dans lequel le boîtier (11) présente une ouverture, le dispositif d'acquisition (10) comprenant en outre :
- un capuchon (14) comprenant un corps (21) propre à obturer l'ouverture du boîtier (11), et
- un connecteur (25) s'étendant à travers le corps (21) du capuchon (14), le connecteur (25) étant propre à être raccordé à un câble de communication, pour transmettre le signal de données entre l'un ou plusieurs des modules électroniques (12) disposés à l'intérieur de la cavité (20) et un équipement distant situé à l'extérieur du boîtier (11).

8. Dispositif d'acquisition selon la revendication 7, comprenant une première plaque d'extrémité (23) disposée entre le capuchon (14) et l'empilement, et dans lequel la première plaque d'extrémité (23) présente une troisième face (39) et comprend un troisième ensemble de pistes conductrices s'étendant sur la troisième face (39), les pistes du troisième ensemble de pistes conductrices étant d'une part raccordées électriquement au connecteur (25) et étant propres d'autre part à être raccordées électriquement aux pistes (37, 38) du premier ensemble de pistes conductrices (32) ou du deuxième ensemble de pistes conductrices (33) de l'un des modules électroniques (12).

9. Dispositif d'acquisition selon l'une des revendications 1 à 8, dans lequel chaque élément de connexion (13) comprend un bloc en matériau électriquement conducteur anisotropique présentant une conductivité électrique élevée selon une première direction parallèle à une direction de la force de compression et une conductivité électrique faible selon une direction perpendiculaire à la direction de la force de compression, de manière à établir la connexion électrique entre chaque piste du premier ensemble de pistes conductrices de l'un des modules électroniques et une piste correspondante du deuxième ensemble de pistes de l'autre des modules électroniques.

10. Dispositif d'acquisition selon la revendication 9, dans lequel le matériau électriquement conducteur anisotropique comprend une matrice non-conductrice et une pluralité d'éléments électriquement conducteurs dispersés dans la matrice, les éléments électriquement conducteurs étant aptes à conduire des signaux électriques selon la première direction uniquement.

11. Dispositif selon la revendication 10, dans lequel la matrice est formée en un matériau élastomère.

12. Dispositif d'acquisition selon l'une des revendications 1 à 11, dans lequel chaque module électronique (12) comprend une première carte électronique (28) présentant la première face (29) sur laquelle s'étend le premier ensemble de pistes conductrices (32), une deuxième carte électronique (30) présentant la deuxième face (31) sur laquelle s'étend le deuxième ensemble de pistes conductrices (33), et un ou plusieurs composant(s) électronique(s) (34) disposé(s) entre la première carte électronique (28) et la deuxième carte électronique (30) et raccordés à l'une des pistes (37) du premier ensemble de pistes conductrices (32) et à l'une des pistes (38) du deuxième ensemble de pistes conductrices (33).

13. Dispositif d'acquisition selon la revendication 11, dans lequel l'un des composants électroniques (34) est propre à recevoir un signal électrique d'entrée contenant des données de mesure via la piste (37) du premier ensemble de pistes conductrices (32) à laquelle le composant électronique (34) est raccordé, à appliquer un traitement aux données de mesure, et à générer un signal électrique de sortie contenant les données de mesure traitées via la piste (38) du deuxième ensemble de pistes conductrices (33) à laquelle le composant électronique (34) est raccordé.

14. Dispositif d'acquisition selon l'une des revendications 12 et 13, dans lequel l'un des composants électroniques (34) est une batterie propre à générer une tension entre la piste (37) du premier ensemble de pistes conductrices (32) à laquelle le composant électronique (34) est raccordé et la piste (38) du deuxième ensemble de pistes conductrices (33) à laquelle le composant électronique (34) est raccordé.

15. Dispositif d'acquisition selon l'une des revendications 12 à 13, dans lequel l'un des composants électroniques (34) est un capteur propre à générer un signal électrique de mesure contenant des données de mesure, tels que par exemple un capteur de vibration, un capteur d'accélération, un capteur acoustique, un capteur de température ou un capteur de pression.

16. Dispositif d'acquisition selon l'une des revendications 12 à 15, dans lequel chaque module électronique (12) comprend un matériau d'enrobage (36) remplissant l'espace entre les composants (34) et les cartes électroniques (28, 30).

17. Dispositif d'acquisition selon l'une des revendications 12 à 15, dans lequel chaque module électronique (12) comprend des parois latérales s'étendant entre la première carte électronique (28) et la deuxième carte électronique (30), de manière à délimiter avec la première carte électronique (28) et la deuxième carte électronique (30) une enceinte de protection contenant le ou les composant(s) électronique(s) (34).

18. Système d'acquisition de données, comprenant :
- une pluralité de dispositifs d'acquisition (10) conformes à l'une des revendications 1 à 17, propres à être fixées en différents endroits d'une structure à instrumenter, et
- un concentrateur de données (50) propre à être raccordé aux différents dispositifs d'acquisition (10) via des câbles de communication (60) ou via des liaisons sans fil (70) pour recevoir des signaux de données de mesure en provenance des différents dispositifs d'acquisition (10).

## Patentansprüche

1. Datenerfassungsvorrichtung (10), die umfasst:
- ein Gehäuse (11), das eine Seitenwand (17) umfasst, die einen Hohlraum (20) abgrenzt,
- eine Vielzahl von elektronischen Modulen (12), die in dem Hohlraum (20) entlang einer Stapelungsrichtung gestapelt sind,
wobei jedes elektronische Modul (12) eine erste Seite (29) und eine zweite Seite (31) umfasst, die der ersten Seite entgegengesetzt ist, und eine erste Menge von Leiterbahnen (32), die sich auf der ersten Seite (29) erstrecken, und eine zweite Menge von Leiterbahnen (33) umfasst, die sich auf der zweiten Seite (31) erstrecken, wobei die erste Menge von Leiterbahnen (32) mindestens eine Leiterbahn (4-8) umfasst, die für die Übertragung eines Datensignals bestimmt ist, und die zweite Menge von Leiterbahnen (33) mindestens eine Leiterbahn (4-8) umfasst, die für die Übertragung des Datensignals bestimmt ist und elektrisch an die Leiterbahn (4-8), die für die Übertragung des Datensignals der ersten Menge von Leiterbahnen (32) bestimmt ist, über einen elektrischen Verbindungsdurchgang angeschlossen ist, der sich im Inneren des elektronischen Moduls erstreckt,
- einen oder mehrere Verbindungsblöcke (13), wobei jeder Verbindungsblock (13) zwischen zwei benachbarten elektronischen Modulen (12A, 12B) der Stapelung angeordnet ist, um eine elektrische Verbindung zwischen jeder Bahn (37) von der ersten Menge von Leiterbahnen (32) von einem der elektronischen Module (12B) und einer entsprechenden Bahn (38) von der zweiten Menge von Bahnen (33) von dem anderen der elektronischen Module (12A) herzustellen,
und
- ein Pressorgan (26), das dazu geeignet ist eine Druckkraft (F) auf die elektronischen Module (12) parallel zur Stapelungsrichtung anzuwenden, wobei die Druckkraft dazu neigt, jeden Verbindungsblock (13) zu verformen, indem eine Abmessung des Verbindungsblocks (13) in einer radialen Richtung senkrecht zur Stapelungsrichtung vergrößert wird, derart dass jeder Verbindungsblock (13) in Anlage gegen die Seitenwand (17) des Gehäuses (11) gehalten wird.

2. Vorrichtung nach Anspruch 1, wobei die Leiterbahnen (4-8) derart gestaltet sind, dass, wenn die elektronischen Module (12) in dem Hohlraum (20) gestapelt sind, unabhängig von der Stapelungsreihenfolge der elektronischen Module (12) in dem Hohlraum (20) die Leiterbahn (4-8), die zur Übertragung des Datensignals auf der zweiten Seite (31) von einem der Module (12A) bestimmt ist, der Leiterbahn (4-8) gegenüberliegt, die zur Übertragung des Datensignals der ersten Seite (29) eines anderen, in der Stapelung benachbarten Moduls (12B) bestimmt ist, um das Datensignal durch die Gesamtheit der Stapelung von einem Modul zum anderen auszubreiten.

3. Vorrichtung nach einem der Ansprüche 1 und 2, wobei mindestens eines der elektronischen Module (12) sich zum Erzeugen des Datensignals eignet.

4. Datenerfassungsvorrichtung nach einem der Ansprüche 1 bis 3, wobei die erste Menge von Leiterbahnen (32) mindestens eine Leiterbahn (1, 3) umfasst, die zur Übertragung eines Synchronisationssignals bestimmt ist, und die zweite Menge von Leiterbahnen (33) mindestens eine Leiterbahn (1, 3) umfasst, die zur Übertragung des Synchronisationssignals bestimmt ist und elektrisch an die Leiterbahn (1, 3) angeschlossen ist, die zur Übertragung des Synchronisationssignals der ersten Menge von Leiterbahnen (32) über einen elektrischen Verbindungsdurchgang angeschlossen ist, der sich im Inneren des elektronischen Moduls erstreckt, wobei die Bahnen (1, 3) derart gestaltet sind, dass, wenn die elektronischen Module (12) in dem Hohlraum (20) gestapelt sind, die Leiterbahn (1, 3), die zur Übertragung des Synchronisationssignals auf der zweiten Seite (31) von einem der Module (12A) bestimmt ist, der Leiterbahn (1, 3) gegenüberliegt, die zur Übertragung des Synchronisationssignals auf der ersten Seite (29) eines anderen der Module (12B) bestimmt ist.

5. Erfassungsvorrichtung nach einem der Ansprüche 1 bis 4, wobei die erste Menge von Leiterbahnen (32) mindestens eine Leiterbahn (2, 9) umfasst, die zur Übertragung eines Versorgungssignals bestimmt ist, und die zweite Menge von Leiterbahnen (33) mindestens eine Leiterbahn (2, 9) umfasst, die zur Übertragung des Versorgungssignals bestimmt ist und elektrisch an die Leiterbahn (2, 9), die zur Übertragung des Versorgungssignals der ersten Menge von Leiterbahnen (32) bestimmt ist, über einen elektrischen Verbindungsdurchgang angeschlossen ist, der sich im Inneren des elektronischen Moduls erstreckt, wobei die Bahnen (2, 9) derart gestaltet sind, dass, wenn die elektronischen Module (12) in dem Hohlraum (20) gestapelt sind, die Leiterbahn (2, 9), die zur Übertragung des Versorgungssignals auf der zweiten Seite (31) von einem der Module (12A) bestimmt ist, der Leiterbahn (2, 9) gegenüberliegt, die zur Übertragung des Versorgungssignals der ersten Seite (29) eines anderen der Module (12B) bestimmt ist.

6. Erfassungsvorrichtung nach einem der Ansprüche 1 bis 5, wobei die erste Menge von Leiterbahnen (32) mindestens eine Leiterbahn (4-8), die zur Übertragung des Datensignals bestimmt ist, eine Leiterbahn (1, 3), die zur Übertragung des Synchronisationssignals bestimmt ist, und eine Leiterbahn (2, 9), die zur Übertragung des Versorgungssignals bestimmt ist, und die zweite Menge von Leiterbahnen (33) mindestens eine Leiterbahn (4-8), die zur Übertragung des Datensignals bestimmt ist, eine Leiterbahn (1, 3), die zur Übertragung des Synchronisationssignals bestimmt ist, und eine Leiterbahn (2, 9), die zur Übertragung des Versorgungssignals bestimmt ist, umfasst, die elektrisch an die Leiterbahn (4-8), die zur Übertragung des Datensignals bestimmt ist, an die Leiterbahn (1, 3), die zur Übertragung des Synchronisationssignals bestimmt ist, beziehungsweise an die Leiterbahn (2, 9), die zur Übertragung des Versorgungssignals der ersten Menge von Leiterbahnen (32) bestimmt ist, über elektrische Verbindungsdurchgänge angeschlossen sind, die sich ausgehend von der ersten Seite (29) bis zur zweiten Seite (31) im Inneren des elektronischen Moduls erstrecken.

7. Datenerfassungsvorrichtung nach einem der Ansprüche 1 bis 6, wobei das Gehäuse (11) eine Öffnung aufweist, wobei die Erfassungsvorrichtung (10) ferner umfasst:
- eine Kappe (14), die einen Körper (21) umfasst, der dazu geeignet ist, die Öffnung des Gehäuses (11) zu verschließen, und
- einen Verbinder (25), der sich durch den Körper (21) der Kappe (14) erstreckt, wobei der Verbinder (25) dazu geeignet ist, an ein Kommunikationskabel angeschlossen zu sein, um das Datensignal zwischen einem oder mehreren der elektronischen Module (12), die im Inneren des Hohlraums (20) angeordnet sind, und einer entfernten Ausrüstung zu übertragen, die sich außerhalb des Gehäuses (11) befindet.

8. Erfassungsvorrichtung nach Anspruch 7, die eine erste Endplatte (23) umfasst, die zwischen der Kappe (14) und der Stapelung angeordnet ist, und wobei die erste Endplatte (23) eine dritte Seite (39) aufweist und eine dritte Menge von Leiterbahnen umfasst, die sich auf der dritten Seite (39) erstrecken, wobei die Bahnen der dritten Menge von Leiterbahnen einerseits elektrisch an den Verbinder (25) angeschlossen sind und andererseits dazu geeignet sind, elektrisch an die Bahnen (37, 38) der ersten Menge von Leiterbahnen (32) oder der zweiten Menge von Leiterbahnen (33) von einem der elektronischen Module (12) angeschlossen zu sein.

9. Erfassungsvorrichtung nach einem der Ansprüche 1 bis 8, wobei jedes Verbindungselement (13) einen Block aus anisotropem elektrisch leitfähigem Material umfasst, das eine hohe elektrische Leitfähigkeit entlang einer ersten Richtung parallel zu einer Richtung der Druckkraft und eine niedrige elektrische Leitfähigkeit entlang einer Richtung senkrecht zur Richtung der Druckkraft aufweist, derart dass die elektrische Verbindung zwischen jeder Bahn von der ersten Menge von Leiterbahnen des einen der elektronischen Module und einer entsprechenden Bahn von der zweiten Menge von Bahnen des anderen der elektronischen Module hergestellt wird.

10. Erfassungsvorrichtung nach Anspruch 9, wobei das anisotrope elektrisch leitfähige Material eine nicht leitfähige Matrix und eine Vielzahl von elektrisch leitfähigen Elementen umfasst, die in der Matrix dispergiert sind, wobei die elektrisch leitfähigen Elemente dazu geeignet sind, elektrische Signale einzig entlang der ersten Richtung zu leiten.

11. Vorrichtung nach Anspruch 10, wobei die Matrix aus einem elastomeren Material gebildet ist.

12. Erfassungsvorrichtung nach einem der Ansprüche 1 bis 11, wobei jedes elektronische Modul (12) eine erste Leiterplatte (28), die die erste Seite (29) aufweist, auf der sich die erste Menge von Leiterbahnen (32) erstreckt, eine zweite Leiterplatte (30), die die zweite Seite (31) aufweist, auf der sich die zweite Menge von Leiterbahnen (33) erstreckt, und ein oder mehrere elektronische Bauteile (34) umfasst, die zwischen der ersten Leiterplatte (28) und der zweiten Leiterplatte (30) angeordnet sind und an eine der Bahnen (37) der ersten Menge von Leiterbahnen (32) und an eine der Bahnen (38) der zweiten Menge von Leiterbahnen (33) angeschlossen sind.

13. Erfassungsvorrichtung nach Anspruch 11, wobei eines der elektronischen Bauteile (34) dazu geeignet ist, ein elektrisches Eingangssignal, das Messdaten enthält, über die Bahn (37) der ersten Menge von Leiterbahnen (32) zu empfangen, an die das elektronische Bauteil (34) angeschlossen ist, eine Verarbeitung auf die Messdaten anzuwenden und ein elektrisches Ausgangssignal, das die verarbeiteten Messdaten enthält, über die Bahn (38) der zweiten Menge von Leiterbahnen (33) zu erzeugen, an die das elektronische Bauteil (34) angeschlossen ist.

14. Erfassungsvorrichtung nach einem der Ansprüche 12 und 13, wobei das eine der elektronischen Bauteile (34) eine Batterie ist, die dazu geeignet ist, eine Spannung zwischen der Bahn (37) der ersten Menge von Leiterbahnen (32), an die das elektronische Bauteil (34) angeschlossen ist, und der Bahn (38) der zweiten Menge von Leiterbahnen (33) zu erzeugen, an die das elektronische Bauteil (34) angeschlossen ist.

15. Vorrichtung nach einem der Ansprüche 12 bis 13, wobei das eine der elektronischen Bauteile (34) ein Sensor ist, der dazu geeignet ist, ein elektrisches Messsignal zu erzeugen, das Messdaten enthält, wie zum Beispiel ein Vibrationssensor, ein Beschleunigungssensor, ein akustischer Sensor, ein Temperatursensor oder ein Drucksensor.

16. Erfassungsvorrichtung nach einem der Ansprüche 12 bis 15, wobei jedes elektronische Modul (12) ein Ümhüllungsmaterial (36) umfasst, das den Raum zwischen den Bauteilen (34) und den Leiterplatten (28, 30) füllt.

17. Erfassungsvorrichtung nach einem der Ansprüche 12 bis 15, wobei jedes elektronische Modul (12) Seitenwände umfasst, die sich zwischen der ersten Leiterplatte (28) und der zweiten Leiterpatte (30) erstrecken, derart dass mit der ersten Leiterplatte (28) und der zweiten Leiterplatte (30) ein abgeschlossener Schutzraum abgegrenzt wird, der das oder die elektronischen Bauteile (34) enthält.

18. Datenerfassungssystem, das umfasst:
- eine Vielzahl von Erfassungsvorrichtungen (10) nach einem der Ansprüche 1 bis 17, die dazu geeignet sind, an verschiedenen Stellen einer zu instrumentierenden Struktur befestigt zu sein, und
- einen Datenkonzentrator (50), der dazu geeignet ist, an die verschiedenen Erfassungsvorrichtungen (10) über Kommunikationskabel (60) oder über drahtlose Verbindungen (70) angeschlossen zu sein, um Messdatensignale zu empfangen, die von den verschiedenen Erfassungsvorrichtungen (10) stammen.

## Claims

1. A data acquisition device (10) comprising:
- a casing (11) comprising a lateral wall (17) delimiting a cavity (20),
- a plurality of electronic modules (12) stacked in the cavity (20) in a stacking direction,
each electronic module (12) having a first face (29) and a second face (31) opposite to the first face, and comprising a first set of conductive tracks (32) extending over the first face (29), and a second set of conductive tracks (33) extending over the second face (31), the first set of conductive tracks (32) comprising at least one conductive track (4-8) dedicated to the transmission of a data signal, and the second set of conductive tracks (33) comprising at least one conductive track (4-8) dedicated to the transmission of a data signal and the second set of conductive tracks (33) comprising at least one conductive track (4-8) dedicated to the transmission of the data signal and electrically connected to the conductive track (4-8) dedicated to the transmission of the first set of conductive tracks (32) via an electrical connection passage extending inside the electronic module,
- one or more connector block(s) (13), each connector block (13) being positioned between two adjacent electronic modules (12A, 12B) of the stack to establish an electrical connection between each track (37) of the first set of conductive tracks (32) of one of the electronic modules (12B) and a corresponding track (38) of the second set of tracks (33) of the other of the electronic modules (12A), and
- a pressing member (26) able to apply a compression force (F) to the electronic modules (12), parallel to the stacking direction, the compression force tending to deform each connector block (13) by increasing a dimension of the connector block (13) in a radial direction, perpendicular to the stacking direction, so as to maintain each connector block (13) supported against the lateral wall (17) of the casing (11) .

2. The device according to claim 1, wherein the conductive tracks (4-8) are arranged so that when the electronic modules (12) are stacked in the cavity (20), regardless of the stacking order of the electronic modules (12) in the cavity (20), the conductive track (4-8) dedicated to the transmission of the data signal on the second face (31) of one of the modules (12A) faces the conductive track (4-8) dedicated to the transmission of the data signal of the first face (29) of another adjacent module (12B) in the stack, to propagate the data signal from one module to another through the totality of the stack.

3. The device according to one of claims 1 and 2, wherein at least one of the electronic modules (12) is able to generate the data signal.

4. The data acquisition device according to one of claims 1 to 3, wherein the first set of conductive tracks (32) comprises at least one conductive track (1, 3) dedicated to the transmission of a synchronization signal, and the second set of conductive tracks (33) comprises at least one conductive track (1, 3) dedicated to the transmission of the synchronization signal and connected electrically to the conductive track (1, 3) dedicated to the transmission of the synchronization signal of the first set of conductive tracks (32) via an electrical connection passage extending inside the electronic module, the tracks (1, 3) being arranged so that when the electronic modules (12) are stacked in the cavity (20), the conductive track (1, 3) dedicated to the transmission of the synchronization signal on the second face (31) of one of the modules (12A) faces the conductive track (1, 3) dedicated to the transmission of the synchronization signal on the first face (29) of another of the modules (12B).

5. The acquisition device according to one of claims 1 to 4, wherein the first set of conductive tracks (32) comprises at least one conductive track (2, 9) dedicated to the transmission of a power supply signal, and the second set of conductive tracks (33) comprises at least one conductive track (2, 9) dedicated to the transmission of the power supply signal and connected electrically to the conductive track (2, 9) dedicated to the transmission of the power supply signal of the first set of conductive tracks (32) via an electrical connection passage extending inside the electronic module, the tracks (2, 9) being arranged so that when the electronic modules (12) are stacked in the cavity (20), the conductive track (2, 9) dedicated to the transmission of the power supply signal on the second face (31) of one of the modules (12A) faces the conductive track (2, 9) dedicated to the transmission of the power supply signal of the first face (29) of another of the modules (12B).

6. The acquisition device according to one of claims 1 to 5, wherein the first set of conductive tracks (32) comprises at least one conductive track (4-8) dedicated to the transmission of the data signal, one conductive track (1, 3) dedicated to the transmission of the synchronization signal and one conductive track (2, 9) dedicated to the transmission of the power supply signal, and the second set of conductive tracks (33) comprises at least one conductive track (4-8) dedicated to the transmission of the data signal, one conductive track (1, 3) dedicated to the transmission of the synchronization signal and one conductive track (2, 9) dedicated to the transmission of the power supply signal, connected electrically respectively to the conductive track (4-8) dedicated to the transmission of the data signal, to the conductive track (1, 3) dedicated to the transmission of the synchronization signal and to the conductive track (2, 9) dedicated to the transmission of the power supply signal of the first set of conductive tracks (32), via electrical connection passages extending from the first face (29) until the second face (31) inside the electronic module.

7. The data acquisition device according to one of claims 1 to 6, wherein the casing (11) has an opening, the acquisition device (10) also comprising:
- a cap (14) comprising a body (21) able to block the opening of the casing (11), and
- a connector (25) extending through the body (21) of the cap (14), the connector (25) being able to be connected to a communication cable, to transmit the data signal between one or more of the electronic modules (12) positioned inside the cavity (20) and distant equipment located outside the casing (11).

8. That acquisition device according to claim 7, comprising a first end plate (23) positioned between the cap (14) and the stack, and wherein the first end plate (23) has a third face (39) and comprises a third set of conductive tracks extending over the third face (39), the tracks of the third set of conductive tracks being, on the one hand, connected electrically to the connector (25) and being able, on the other hand, to be connected electrically to the tracks (37, 38) of the first set of conductive tracks (32), or of the second set of conductive tracks (33) of one of the electronic modules (12) .

9. The acquisition device according to one of claims 1 to 8, wherein each connection element (13) comprises a block of anisotropic electrically conductive material having high electrical conductivity in a first direction parallel to a direction of the compression force and low electrical conductivity in a direction perpendicular to the direction of the compression force, so as to establish the electrical connection between each track of the first set of conductive tracks of one of the electronic modules and a corresponding track of the second set of tracks of the other of the electronic modules.

10. The acquisition device according to claim 9, wherein the anisotropic electrically conductive material comprises a non-conductive matrix and a plurality of electrically conductive elements dispersed in the matrix, the electrically conductive elements being able to conduct electrical signals only in the first direction.

11. The device according to claim 10, wherein the matrix is formed of an elastomeric material.

12. The acquisition device according to one of claims 1 to 11, wherein each electronic module (12) comprises a first electronic board (28) having the first face (29) on which the first set of conductive tracks (32) extends, a second electronic board (30) having the second face (31) on which the second set of conductive tracks (33) extends, and one or more electronic component(s) (34) positioned between the first electronic board (28) and the second electronic board (30) and connected to one of the tracks (37) of the first set of conductive tracks (32) and to one of the tracks (38) of the second set of conductive tracks (33).

13. The acquisition device according to claim 11, wherein one of the electronic components (34) is able to receive an input electrical signal containing measurement data via the track (37) of the first set of conductive tracks (32) to which the electronic component (34) is connected, to apply processing to the measurement data, and to generate an electrical output signal containing the processed measurement data via the track (38) of the second set of conductive tracks (33) to which the electronic component (34) is connected.

14. The acquisition device according to one of claims 12 and 13, wherein one of the electronic components (34) is a battery able to generate a voltage between the track (37) of the first set of conductive tracks (32) to which the electronic component (34) is connected and the track (38) of the second set of conductive tracks (33) to which the electronic component (34) is connected.

15. The acquisition device according to one of claims 12 to 13, wherein one of the electronic components (34) is a sensor able to generate an electrical measurement signal containing measurement data, such as for example a vibration sensor, an acceleration sensor, an acoustic sensor, a temperature sensor or a pressure sensor.

16. The acquisition device according to one of claims 12 to 15, wherein each electronic module (12) comprises a potting material (36) filling the space between the components (34) and the electronic boards (28, 30).

17. The acquisition device according to one of claims 12 to 15, wherein each electronic module (12) comprises lateral walls extending between the first electronic board (28) and the second electronic board (30), so as to delimit, with the first electronic board (28) and the second electronic board (30), a protective housing containing the electronic component(s) (34).

18. A data acquisition system, comprising:
- a plurality of acquisition devices (10) conforming to one of claims 1 to 17, able to be attached at different locations of a structure to be instrumented, and
- a data concentrator (50) able to be connected to the different acquisition devices (10) via communication cables (60) or via wireless connections (70) to receive measurement data signals originating in the different acquisition devices (10).
